# EUROPÄISCHE PATENTANMELDUNG

(11) **EP 2 388 824 A2**
(43) Veröffentlichungstag der Anmeldung: **23.11.2011**
(21) Anmeldenummer: 11004051.6
(22) Anmeldetag: 17.05.2011
(51) Int. Cl.: H01L 29/872, H01L 29/24, H01L 29/47

(54) **Elektronisches Bauelement und seine Verwendung**

(30) Priorität: 22.05.2010 DE 102010021344
(71) Anmelder: Karlsruher Institut Für Technologie (KIT), 76131 Karlsruhe (DE)
(72) Erfinder: Rheinheimer, Wolfgang, 76185 Karlsruhe (DE); Bäurer, Michael, 75015 Bretten (DE)
(74) Vertreter: Gärtner, Stephan

(57) **Zusammenfassung**

Die Erfindung betrifft ein elektronisches Bauelement, das eine Schicht (1) aus einem n-leitenden Halbleiter, der bei Raumtemperatur einen O₂-Diffusionskoeffizienten von mindestens 10⁻¹⁸ cm²/s aufweist, umfasst, wobei die Schicht (1) zwischen einer Metallelektrode (2) und einer barrierefreien Elektrode (3) angeordnet ist und Mittel (4) zum Anlegen einer elektrischen Spannung zwischen der Metallelektrode (2) und der barrierefreie Elektrode (3) vorgesehen sind.

Die Erfindung betrifft weiterhin die Verwendung eines solchen elektronischen Bauelements als Schottky-Diode mit einer im Betrieb veränderlichen Kennlinie, die sich insbesondere zum Einsatz in einer elektronischen Schaltung als Schutzelement zur Spannungsbegrenzung eignet.

## Beschreibung

Die Erfindung bettrift ein elektronisches Bauelement und seine Verwendung.

Eine Schottky-Diode besitzt gegenüber einer Diode keinen Halbleiter-Halbleiter-Übergang (p-n-Übergang), sondern einen Metall-Halbleiter-Übergang. An der Grenzfläche zwischen dem Metall und dem Halbleiter, die als Schottky-Kontakt bezeichnet wird, bildet sich zwischen der Fermikante des Metalls und der Leitungsband-Unterkante des Halbleiters eine Schottky-Barriere aus, die dazu führt, dass Elektronen den Halbleiter verlassen und eine Verarmungszone (*depletion zone*) entsteht.

Wird an die Schottky-Diode eine Spannung mit Minuspol am n-Halbleiter angelegt, wandern Elektronen aus dem Halbleiter in die Verarmungszone, wodurch sich die Schottky-Barriere erniedrigt und Elektronen schließlich aus dem Halbleiter in das Metall gelangen (Vorwärtsrichtung). Auf diese Weise nimmt der elektrische Widerstand der Schottky-Diode in Vorwärtsrichtung ab.

Wird dagegen an die Schottky-Diode eine niedrige Spannung mit Minuspol am Metall angelegt, nehmen Dicke und Höhe der Verarmungszone zu (Sperrrichtung), so dass sich nur ein kleiner Strom ausbildet, da nur wenige Elektronen des Metalls die Schottky-Barriere durch thermische Anregung oder Quantentunneln überwinden. Auf diese Weise nimmt der elektrische Widerstand der Schottky-Diode in Sperrrichtung zu.

Bei Anlegen einer hohen negativen Spannung mit Minuspol am n-Halbleiter (Sperrrichtung) lassen sich Durchbrüche durch die Schottky-Barriere beobachten.

Die Höhe der Schottky-Barriere wird durch die Differenz der Austrittsarbeiten aus Metall und Halbleiter und im Wesentlichen durch die Höhe der Bindung zwischen Metall und Halbleiter sowie durch Prozessparameter, insbesondere der Art der Oberflächenbehandlung, bestimmt und ist somit durch die Auswahl der Materialien und ihre Prozessierung festgelegt.

Aus P.C. McIntyre, Point defect equilibrium in strontium titanate thin films, J. Appl. Phys. 89, 8074, 2001, ist bekannt, dass Strontiumtitanat wie alle Materialen der Perowskitgruppe eine sehr ausgeprägte Beweglichkeit von zweifach positiv geladenen Sauerstoffatomen O²⁻ im Kristallgitter mit O₂-Diffusionskoeffizienten Dₒ von mindestens 10⁻¹⁶ cm²/s aufweist.

M. Mrovec, J.-M. Albina, B. Meyer, und C. Elsässer, Schottky barriers at transition-metal/SrTiO3(001) interfaces, Physical Review B 79, 245121, 2009, berechnen die Höhe von Schottky-Barrieren für eine Reihe von Grenzflächen zwischen Übergangsmetallen und dem Perowskit Strontiumtitanat.

J.J. Yang, J. Borghetti, D. Murphy, D.R. Stewart und R.S. Williams, A Family of Electronically Reconfigurable Nanodevices, Adv. Mater. 2009, 21, 3754-3758, beschreiben Memristoren, d.h. passive elektronische Bauteile, deren Widerstand vom Stromfluss der Vergangenheit abhängig ist und die aus zwei Schichten aus Titandioxid bestehen, die sich zwischen zwei Platinkontakten befinden. Eine der beiden Schichten weist weniger Sauerstoff-Atome auf und zeigt im Vergleich mit der anderen Schicht eine höhere elektrische Leitfähigkeit.

Ausgehend hiervon ist es die Aufgabe der vorliegenden Erfindung, ein weiteres elektronisches Bauelement und seine Verwendung vorzuschlagen.

Insbesondere soll ein elektronisches Bauelement bereitgestellt werden, das eine Kennlinie aufweist, die sich während des Betriebs des Bauelements durch äußere Bedingungen festlegen oder verändern lässt.

Diese Aufgabe wird im Hinblick auf das elektronische Bauelement durch Merkmale des Anspruchs 1 und im Hinblick auf dessen Verwendung durch die Ansprüche 7 und 9 gelöst. Die Unteransprüche beschreiben jeweils vorteilhafte Ausgestaltungen der Erfindung.

Eine erfindungsgemäße Vorrichtung enthält eine Schicht aus einem n-leitenden Halbleiter, der bei 25 °C (Raumtemperatur) einen O₂-Diffuszonskoeffizienten von mindestens 10⁻¹⁸ cm²/s, bevorzugt von mindestens 10⁻¹⁶ cm²/s besitzt.

In einer bevorzugten Ausgestaltung enthält die Schicht einen Perowskit, vorzugsweise dotiertes CaTiO₃, SrTiO₃, BaTiO₃, CaZrO₃ oder CaSnO₃, insbesondere mit von 0,1 bis 10 Mol% Niob dotiertes SrTiO₃, wobei der jeweils zugehörige O₂-Diffusionskoeffizient Dₒ einen Wert von mindestens 10⁻¹⁸ cm²/s erreichen, bevorzugt von mindestens 10⁻¹⁶ cm²/s muss.

Diese Schicht aus einem derartigen n-Halbleiter ist weiterhin zwischen einer Metallelektrode und einer barrierefreien Elektrode angeordnet.

Unter einer *barrierefreien Elektrode* wird ein elektrisch leitfähiges Material verstanden, das mit dem hieran angrenzenden n-Halbleiter keinen Schottky-Kontakt und damit weder eine Schottky-Barriere (Potentialbarriere) noch eine Verarmungszone ausbildet. Hierzu eignet sich vorzugsweise eine Legierung, die mindestens zwei der Elemente Indium, Gallium und Zinn enthält. In einer besonders bevorzugten Ausgestaltung wird insbesondere in den Fällen, in denen der in der Regel flüssige Aggregatzustand der genannten Legierungen unvorteilhaft ist, die barrierefreie Elektrode in Form einer YBa₂Cu₅O₆₊ₓ-Sputterschicht bereitgestellt.

Weiterhin wird eine *Metallelektrode* eingesetzt, die im Unterschied zur barrierefreien Elektrode mit dem hieran angrenzenden n-Halbleiter einen Schottky-Kontakt und damit eine Schottky-Barriere (Potentialbarriere) und eine Verarmungszone ausbildet.

Bevorzugt wird hierzu eine *Metallelektrode,* die Gold, Silber, Kupfer, Platin, Aluminium oder Nickel enthält, eingesetzt.

Schließlich enthält das erfindungsgemäße Bauelement Mittel zum Anlegen einer elektrischen Spannung zwischen der Metallelektrode und der barrierefreien Elektrode.

Die Funktionsweise eines erfindungsgemäßen Bauelements lässt sich wie folgt erklären.

Das Inkontaktbringen der Schicht aus einem n-leitenden Halbleiter, der bei Raumtemperatur einen O₂-Diffusionskoeffizienten von mindestens 10⁻¹⁸ cm²/s, bevorzugt von mindestens 10⁻¹⁶ cm²/s, besitzt, mit einer Metallelektrode führt zur Ausbildung einer Schottky-Barriere, die durch einen hohen Widerstand der Grenzfläche zwischen der n-halbleitenden Schicht und der Metallelektrode, der wesentlich höher als der der n-halbleitenden Schicht ist, sowie durch eine Abhängigkeit von der Polarität einer hieran angelegten Spannung gekennzeichnet ist.

Wird an ein erfindungsgemäßes Bauelement, das eine n-halbleitenden Schicht mit einem O₂-Diffusionskoeffizienten von mindestens 10⁻¹⁶ cm²/s bei Raumtemperatur besitzt, eine negative Spannung mit Minuspol an der Metallelektrode angelegt, wandern die Sauerstoff-Leerstellen aufgrund ihrer hohen Beweglichkeit in Richtung des Schottky-Kontakts. Dadurch verringert sich die Höhe der Schottky-Barriere, so dass der elektrische Widerstand der Schottky-Diode in Sperrrichtung abnimmt. Der Abfall des elektrischen Widerstands erfolgt umso schneller, je höher die angelegte Spannung ist.

Wird die beschriebene Spannung wieder abgeschaltet, geht die die Verteilung der Sauerstoff-Leerstellen durch Rückdiffusion wieder in den ursprünglichen Zustand zurück, so dass der elektrische Widerstand des Bauelements wieder auf den ursprünglichen Wert zurückgeht. Die Zeitkonstante für diesen Vorgang liegt bei Raumtemperatur im Bereich von 1 bis 10 Tagen, lässt sich durch eine höhere Temperatur jedoch erheblich verkürzen.

Da sich die Verteilung der Sauerstoff-Leerstellen durch Diffusion einstellt, ist dieser Vorgang vollständig reversibel. Dies hat zur Folge, dass es möglich ist, wie oben beschrieben, beliebig oft eine Spannung in Sperrrichtung an das erfindungsgemäße Bauelement zu legen und wieder abzuschalten, wodurch der elektrische Widerstand des Bauelements erst deutlich abnimmt, um nach dem Abschalten der Spannung nach einer gewissen Zeit wieder den ursprünglichen Wert anzunehmen.

Auf diese Weise wird eine Schottky-Diode erhalten, die einen im Betrieb veränderlichen elektrischen Widerstand besitzt, d.h. eine von der Höhe und Polarität einer hieran angelegten Spannung veränderliche Kennlinie aufweist.

Ein erfindungsgemäßes Bauelement wird daher als Schottky-Diode mit einer im Betrieb veränderlichen Kennlinie verwendet. Auf diese Weise wird ein flexibles Halbleiter-Bauelement erhalten. Weiterhin ist ein Einsatz eines erfindungsgemäßen Bauelements ähnlich einem Memristor möglich. Zu diesem Zweck wird das Bauelement an beiden Seiten vorzugsweise mit einer gesputterten Goldelektrode versehen.

In einer bevorzugten Ausgestaltung lässt sich das elektronische Bauelement in einer elektronischen Schaltung als Schutzelement, insbesondere als Schutzelement mit Gedächtnisfunktion, verwenden. Wird in eine elektronische Schaltung ein erfindungsgemäßes Bauelement als Schottky-Diode in Sperrrichtung parallel zu einer überlastungsempfindlichen Elektronik eingebracht, würde eine Überspannung den elektrischen Widerstand im Bauelement verringern, so dass die Überspannung durch das Bauelement abfließen und somit die überlastungsempfindliche Elektronik nicht beschädigen würde. Die Schutzfunktion lässt sich anschließend durch Abwarten oder durch eine Temperaturbehandlung wieder umkehren. Somit wird hier durch ein einzelnes Bauelement eine komplexe Schutzfunktion realisiert.

Die Erfindung wird im Folgenden anhand von Ausführungsbeispielen und den Figuren näher erläutert. Hierbei zeigen:
- **Fig. 1**: Schematische Darstellung eines erfindungsgemäßen elektronischen Bauelements;
- **Fig. 2**: Elektrischer Widerstand gegenüber der Zeit in einer Versuchsreihe, durchgeführt mit einem erfindungsgemäßen elektronischen Bauelement;
- **Fig. 3**: Schematische Darstellung eines erfindungsgemäßen elektronischen Bauelements in Verwendung in einer elektronischen Schaltung als Schutzelement.

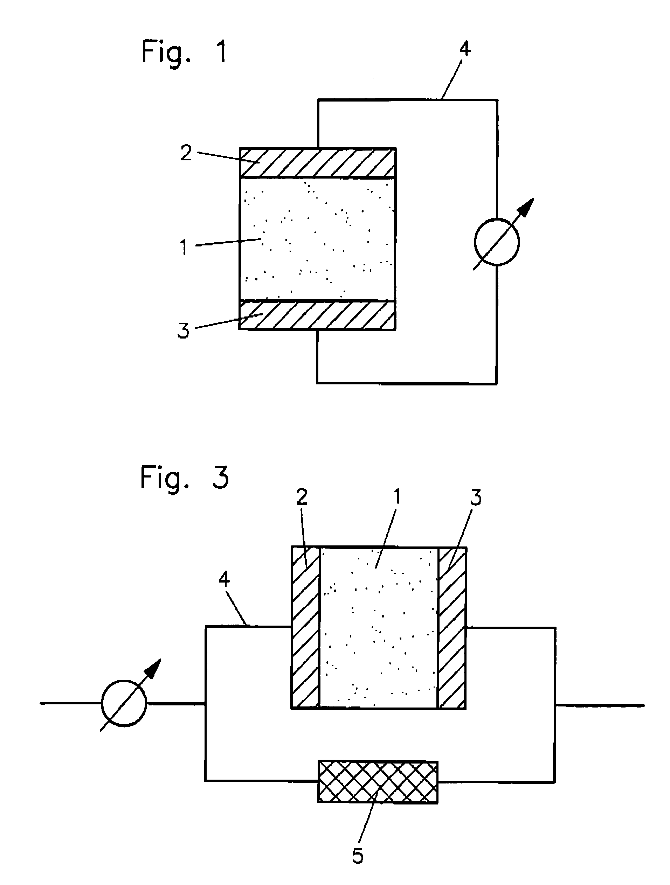

**Fig. 1** zeigt schematisch eine Ausführung eines erfindungsgemäßen elektronischen Bauelements. Für eine Schicht 1 wurden mit 1 mol% Niob dotierte SrTiO₃-Einkristalle mit Abmessungen von 0,5 mm x 4,5 mm x 4,5 mm jeweils in (100)-Richtung-geschnitten und auf einer Seite poliert. Nach einer Reinigung mit Aceton und 2-Propanol wurden auf einer Seite (Oberseite) der Schicht **1** Metallelektroden **2** aus Gold aufgebracht, während auf die gegenüberliegende Seite (Unterseite) der Schicht **1** eine Schicht aus Indium-Gallium als barrierefreie Elektrode **3** aufgebracht wurde. Schließlich wurden die Metallelektrode **2** und die barrierefreie Elektrode **3** mit elektrisch leitfähigen Kontakten als Mitteln **4** zum Anlegen einer elektrischen Spannung an das elektronische Bauelement zwischen die Metallelektrode **2** und die barrierefreie Elektrode **3** versehen.

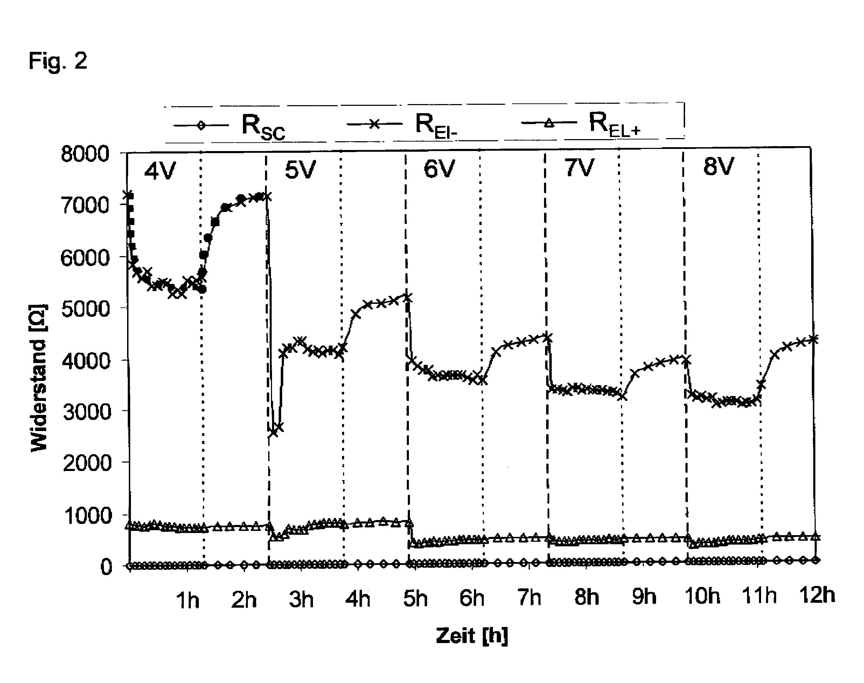

In **Fig. 2** sind Ergebnisse aus einer Versuchsreihe unter Verwendung eines erfindungsgemäßen elektronischen Bauelements dargestellt. In 5 Zyklen wurde über die Mittel **4** jeweils eine Gleichspannung in Höhe von 4 V bis 8 V an das elektronische Bauelement, das einen elektrischen Widerstand von 5 Ω aufwies, angelegt. Die jeweils angelegte Spannung wurde alle 210 s kurz unterbrochen, um jeweils eine Impedanzmessung bei niedrigerer Spannung durchzuführen. Nach 15 Messungen wurde die Gleichspannung in Höhe von 4 V bis 8 V vollständig abgeschaltet und 5 weitere Impedanzmessungen bei niedrigerer Spannung im Intervall von 300 s vorgenommen. Insgesamt wurden 5 derartige Zyklen durchgeführt, wobei die Gleichspannung jeweils in 1 Volt-Schritten von 4 V auf 8 V erhöht wurde.

Zu Beginn jedes Zyklus zeigt, wie in **Fig. 2** dargestellt, der elektrische Widerstand während des Anlegens der Gleichspannung einen exponentiellen Abfall, um dann auf einen annähernd konstanten Wert zuzulaufen. Nach dem Abschalten der Gleichspannung auf 0 Volt konnte jeweils eine exponentielle Zunahme des elektrischen Widerstands beobachtet werden. Der beobachtete Verlauf des elektrischen Widerstands war in allen Zyklen sehr ähnlich, es zeigte sich jedoch eine Abnahme des Widerstandsniveaus mit zunehmender Höhe der angelegten Gleichspannung.

Zu Beginn des 2. Zyklus wurde ein kurzer Zusammenbruch des elektrischen Widerstands beobachtet. Als Ursache hierfür wird ein lokaler elektrischer Zusammenbruch in der Probe vermutet, da der geringe Widerstand des Halbleiters bei einer angelegten Gleichspannung von 5 V über eine Kontaktfläche mit einer Dicke von nur etwa 200 nm zu einem hohen Wert des elektrischen Felds von ca. 12,5 kV/mm führt.

Die in **Fig. 2** dargestellten Impedanzmessungen wurden jeweils mit einer Vorspannung (Bias) von 0,05 V und einer Amplitude der Wechselspannung von 0,01 V bei Raumtemperatur im Frequenzbereich von 20 Hz bis 1 MHz vorgenommen.

**Fig. 3** zeigt schließlich schematisch eine besonders bevorzugte Verwendung eines erfindungsgemäßen elektronischen Bauelements in einer elektronischen Schaltung als Schutzelement. Hierzu wird parallel zu einem überlastungsempfindlichen Bauelement **5,** an dessen Stelle sich auch eine Baugruppe oder eine elektronische Schaltung befinden kann, ein erfindungsgemäßes elektronisches Bauelement mit der von der Metallelektrode **2** und der barrierefreien Elektrode **3** umgebenen n-halbleitenden Schicht **1** als Schottky-Diode in Sperrrichtung eingebracht.

Trifft eine Überspannung auf die dargestellte Parallelschaltung, verringert diese den elektrischen Widerstand im erfindungsgemäßen Bauelement, wodurch der durch die Überspannung hervorgerufene Strom durch das erfindungsgemäße Bauelement abfließt und das überlastungsempfindliche Bauelement **5** nicht beschädigt.

Die Gedächtnisfunktion des elektronischen Bauelements wird dadurch erhalten, dass sich durch eine Temperaturbehandlung der Schottky-Diode oder durch einfaches Abwarten der ursprüngliche elektrische Widerstand des erfindungsgemäßen Bauelements wieder einstellt.

## Patentansprüche

1. Elektronisches Bauelement, umfassend eine Schicht (1) aus einem n-leitenden Halbleiter, der bei Raumtemperatur einen O₂-Diffusionskoeffizienten von mindestens 10⁻¹⁸ cm²/s aufweist, die zwischen einer Metallelektrode (2) und einer barrierefreien Elektrode (3) angeordnet ist, und Mitteln (4) zum Anlegen einer elektrischen Spannung zwischen die Metallelektrode (2) und die barrierefreie Elektrode (3).

2. Elektronisches Bauelement nach Anspruch 1, wobei die Schicht (1) einen Perowskit umfasst.

3. Elektronisches Bauelement nach Anspruch 2 mit dotiertem CaTiO₃, SrTiO₃, BaTiO₃, CaZrO₃ oder CaSnO₃ als Perowskit.

4. Elektronisches Bauelement nach einem der Ansprüche 1 bis 3, wobei die Metallelektrode (2) Gold, Silber, Kupfer, Platin, Aluminium oder Nickel aufweist.

5. Elektronisches Bauelement nach einem der Ansprüche 1 bis 4, wobei die barrierefreie Elektrode (3) eine Legierung, die mindestens zwei der Elemente Indium, Gallium und Zinn umfasst, aufweist.

6. Elektronisches Bauelement nach einem der Ansprüche 1 bis 4, wobei die barrierefreie Elektrode (3) eine Schicht, die YBa₂Cu₅O₆₊ₓ enthält, aufweist .

7. Verwendung eines elektronischen Bauelements nach einem der Ansprüche 1 bis 6 als Schottky-Diode mit einer im Betrieb veränderlichen Kennlinie.

8. Verwendung eines elektronischen Bauelements nach Anspruch 7 in einer elektronischen Schaltung als Schutzelement zur Spannungsbegrenzung.

9. Verwendung eines elektronischen Bauelements nach einem der Ansprüche 1 bis 6 als Memristor.
